# EUROPÄISCHE PATENTSCHRIFT

(11) **EP 4 206 622 B1**
(45) Veröffentlichungstag und Bekanntmachung des Hinweises auf die Patenterteilung: **28.05.2025**
(21) Anmeldenummer: 21218510.2
(22) Anmeldetag: 31.12.2021
(51) Int. Cl.: G01G 21/28, G01G 23/00

(54) **LADENWAAGE**
SHOP SCALES
BALANCE DE MAGASIN

(43) Veröffentlichungstag der Anmeldung: 05.07.2023
(60) Teilanmeldung: 23000187.7
(73) Patentinhaber: Bizerba SE & Co. KG, 72336 Balingen (DE)
(72) Erfinder: BUHL, Steffen, 72474 Winterlingen (DE); KEINATH, Steffen, 72393 Burladingen (DE)
(74) Vertreter: Huber, Meik

(56) Entgegenhaltungen:
- DE-A1- 102009 049 567
- DE-A1- 102011 083 562
- DE-U1- 202011 050 040

## Beschreibung

Die vorliegende Erfindung betrifft eine Waage, insbesondere eine Ladenwaage, mit einem Wägemodul. Das Wägemodul umfasst ein Gehäuse, in dem eine Wägezelle untergebracht ist. Die Wägezelle umfasst einen festen Abschnitt, einen Verformungsabschnitt und einen beweglichen Abschnitt. Der feste Abschnitt ist mit dem Gehäuse verbunden und der bewegliche Abschnitt trägt ein Lastkreuz mit einer Lastplatte. Der Verformungsabschnitt weist einen Dehnungsmesstreifen zur Messung eines auf die Lastplatte wirkenden Gewichts auf.

Die DE 20 2011 050 040 U1 zeigt eine Haushaltswaage, deren Lastplatte mit einer Schreibfläche ausgestattet ist, die mit einem Stift beschriftet werden kann. Dabei ist die Schreibfläche transluzent ausgeführt von hinten und beleuchtet.

Die DE 10 2011 083 562 A1 zeigt eine Personenwaage, die eine Lichtquelle umfasst, die unterhalb der Lastplatte angeordnet ist und den unteren Bereich der Waage ausleuchtet.

Die DE 10 2009 049 567 A1 zeigt eine Personenwaage mit einer Anzeigevorrichtung, die einer zu wiegenden Person Rückmeldung darüber gibt, ob sie korrekt auf der Lastplatte steht.

Ladenwaagen sind dem Fachmann gut bekannt. Diese Waagen umfassen in aller Regel ein Bedienerdisplay zur Interaktion mit der Waage, zum Beispiel zum Anzeigen eines Gewichts oder zum Anzeigen von Fehlfunktionen. Dabei muss der Bediener durch verschiedene Menüebenen navigieren, um bestimmte Informationen über den Zustand der Waage zu erhalten. Dies ist für den Bediener oft aufwändig und wenig intuitiv.

Aufgabe der Erfindung ist es, eine einfache Vorrichtung zu schaffen, die den Bediener über den technischen Zustand der Waage in Kenntnis setzt und ihm die Interaktion mit der Waage erleichtert.

Diese Aufgabe wird durch eine Waage mit den Merkmalen des Anspruchs 1 gelöst.

Erfindungsgemäß wird eine Waage, insbesondere eine Ladenwaage vorgeschlagen. Die Waage umfasst ein Wägemodul. Das Wägemodul umfasst ein Gehäuse, in dem eine Wägezelle untergebracht ist. Die Wägezelle umfasst einen festen Abschnitt, einen Verformungsabschnitt und einen beweglichen Abschnitt. Der feste Abschnitt ist mit dem Gehäuse verbunden. Der bewegliche Abschnitt trägt ein Lastkreuz mit einer Lastplatte. Der Verformungsabschnitt weist einen Dehnungsmesstreifen zur Messung eines auf die Lastplatte wirkenden Gewichts auf. An der Außenwand des Gehäuses ist ein Leuchtband im Wesentlichen umlaufend am Gehäuse angebracht. Im Wesentlichen umlaufend in diesem Zusammenhang meint, dass das Leuchtband drei Seiten und einen großen Teil der vierten Seite des Gehäuses umläuft, jedoch dass der Anfang und das Ende des Leuchtbandes nicht verbunden oder zusammentreffen müssen. Ein Abstand zwischen Anfang und Ende des Leuchtbandes, auf der Seite, auf der sich Anfang und Ende begegnen, ist damit ebenfalls gemeint. Die Waage umfasst eine Steuereinheit mit einer Zustandsmaschine, die mindestens einen technischen Zustand der Waage abbildet, wobei die Steuereinheit das Leuchtband aufgrund des Zustands der Zustandsmaschine ansteuert. In einer ersten Ausführungsform beaufschlagt die Steuereinheit das Leuchtband gepulst mit einer Spannung, wenn die Zustandsmaschine in einem ersten Zustand ist. Das heißt, die Spannung wird regelmäßig angeschaltet und ausgeschaltet. Dadurch entsteht ein Blinken des Leuchtbandes. Dabei ist die Frequenz und die Länge der Spannungspulse so zu wählen, dass das menschliche Auge das Leuchtband als blinkend wahrnimmt. Wenn die Zustandsmaschine in einem zweiten Zustand ist, beaufschlagt die Steuereinheit das Leuchtband permanent mit einer Spannung. Das heißt, das Leuchtband leuchtet dauerhaft.

In einer Ausführungsform besteht das Leuchtband aus einem flexiblen Träger. Auf dem flexiblen Träger sind die LED-Leuchtmittel angeordnet. In einer Ausführungsform umfasst der Träger eine bis zehn LED-Leuchtmittel pro cm Länge.

In einer Ausführungsform ist der technische Zustand, der durch die Zustandsmaschine abgebildet wird, ein Papiervorrat in einem Drucker.

In einer Ausführungsform ist der technische Zustand, der durch die Zustandsmaschine abgebildet wird, eine Differenz zu einem Zielgewicht, die durch das durch die Wägezelle ermittelte Gewicht und das Zielgewicht gebildet wird. In einer Ausführungsform ist der technische Zustand, der durch die Zustandsmaschine abgebildet wird, ein veralteter Softwarestand, der durch Updates aktualisiert werden muss. In einer Ausführungsform ist der technische Zustand, der durch die Zustandsmaschine abgebildet wird, eine Geschwindigkeit verschiedener Gewichtserfassungsschritte oder über ein Bedienerdisplay eingegebener Bearbeitungsschritte. In einer Ausführungsform ist der technische Zustand, der durch die Zustandsmaschine abgebildet wird, dass sich ein Bediener korrekt an der Waage über das Bedienerdisplay identifiziert hat.

In einer Ausführungsform ist das Gehäuse einstückig und wannenförmig ausgebildet. Der Fachmann versteht unter einem einstückig und wannenförmig ausgebildeten Gehäuse eine Form eines Gehäuses, die einer Wanne ähnelt. Sie hat eine quadratische oder rechteckige Grundfläche, wobei die Ecken abgerundet sein können. Das Gehäuse hat einen Grundkörper, der in einer Ausführungsform aus einem Metallguss hergestellt ist und somit auch komplexe Formen, insbesondere Öffnungen und innere Wandungen aufweisen kann. Die Länge und die Breite des Gehäuses sind wesentlich größer als dessen Höhe. Das Gehäuse umfasst eine Bodenplatte mit seitlichen Wänden, die einstückig an der Bodenplatte ausgebildet sind. Das Gehäuse ist oben offen und mit einem Freiraum im Inneren, um unterschiedliche Module, wie die Wägezelle, elektronische Module und Anderes im Inneren des Gehäuses aufzunehmen. In einer Ausführungsform ist der Innenbereich des Gehäuses oben mit einer Abdeckung abgedeckt. Unter den Begriff einstückig und wannenförmig fällt auch ein Gehäuse, das im Inneren Trennwände für verschiedene Räume oder Stabilisierungsstreben hat. Des Weiteren fällt auch ein Gehäuse darunter, dessen Bodenplatte an einigen Stellen stufenförmig ausgebildet ist, so dass an diesen Stellen des Gehäuses unterhalb der Bodenplatte des Gehäuses ein Freiraum entsteht, wenn der Grundkörper auf einer ebenen Fläche abgesetzt wird. Dieser Freiraum dient zum Beispiel für das Anbringen von Steckern unterhalb des Gehäuses. Das Gehäuse ist auch dann als einstückig und wannenförmig zu verstehen, wenn an verschiedenen Stellen in der, insbesondere abgestuften, Bodenplatte oder seitlichen Wänden Durchgangsöffnungen vorhanden sind, zum Beispiel für das Anbringen von Steckerbuchsen, das Durchführen von Kabeln oder die Montage von Trägern und anderen Elementen der Waage. Der Begriff wannenförmig ist deswegen nur als beschreibend für das grundsätzliche Erscheinungsbild des Gehäuses anzusehen.

In einer Ausführungsform handelt es sich bei der Zustandsmaschine um einen endlichen Automaten, der aus Zuständen, Zustandsübergängen und Aktionen besteht.

In einer Ausführungsform umfasst die Steuereinheit einem Speicher, in dem ein Zielgewicht hinterlegt ist. Die Zustandsmaschine befindet sich in dem zweiten Zustand, wenn der durch die Wägezelle gemessene Gewichtswert dem Zielgewicht entspricht. Die Zustandsmaschine befindet sich in dem ersten Zustand, wenn der durch die Wägezelle gemessene Gewichtswert vom Zielgewicht abweicht. Dabei ist das Zielgewicht nicht als diskrete Gewichtsangabe zu verstehen. Vielmehr handelt es sich beim Zielgewicht um einen Gewichtsbereich, das heißt um eine diskrete Gewichtsangabe mit einer gewissen Toleranz, zum Beispiel 5 % oder 10 %. So ist das Zielgewicht bei einer Nutzung der Waage im Lebensmittelbereich zum Beispiel 190 g - 210 g. Befindet sich der von der Wägezelle gemessene Gewichtswert in diesem Band, dann entspricht er dem Zielgewicht und die Zustandsmaschine befindet sich in einem zweiten Zustand. Befindet sich der von der Wägezelle gemessene Gewichtswert außerhalb dieses Bandes, zum Beispiel bei 180 g, so weicht der durch die Wägezelle gemessene Gewichtswert vom Zielgewicht ab und die Zustandsmaschine befindet sich im ersten Zustand. Der Fachmann versteht also den Ausdruck Zielgewicht als Angabe eines Gewichtsbereichs, wobei die Breite des Gewichtsbereichs im Vergleich zum absoluten Gewichtswert klein ist. Auf diese Weise kann der Bediener mit der Waage interagieren, wenn er über das Leuchtband darauf hingewiesen wird, ob er weitere Produkte, zum Beispiel Scheiben von Lebensmitteln, auf die Lastplatte der Waage legen muss, um ein Zielgewicht zu erreichen, bzw. dass die Waage mit dem Leuchtband das Erreichen des Zielgewichts signalisiert. Die Waage führt so die Interaktion des Bedieners mit der Waage.

In einer Ausführungsform ist in einem Speicher in der Steuereinheit eine Zielstückzahl und ein durchschnittliches Gewicht pro Stück hinterlegt. Die Steuereinheit ermittelt durch Multiplikation von Zielstückzahl mit dem durchschnittlichen Gewicht pro Stück ein Zielgewicht. Der von der Wägezelle gemessene Gewichtswert wird dann mit dem Zielgewicht verglichen. Ist eine der Zielstückzahl entsprechende Anzahl an Gegenständen mit dem spezifischen Gewicht auf der Waage platziert, so wird das Zielgewicht erreicht und von der Wägezelle gemessen. In diesem Fall befindet sich die Zustandsmaschine im zweiten Zustand. Sind mehr oder weniger Stück als die Zielstückzahl eines Produkts mit einem entsprechenden Gewicht auf der Waage, so wird das entsprechend berechnete Zielgewicht überschritten oder unterschritten. Der durch die Wägezelle gemessene Gewichtswert weicht vom Zielgewicht ab, dass sich die Zustandsmaschine im ersten Zustand befindet. Entsprechend wird durch die Steuereinheit das Leuchtband angesteuert. Die Waage signalisiert dem Nutzer auf diese Art, ob eine gewünschte Anzahl eines Produktes abgezählt wurde. Auf diese Weise kann der Bediener mit der Waage interagieren, wenn er über das Leuchtband darauf hingewiesen wird, ob er weitere Produkte, zum Beispiel Stückgut, auf die Lastplatte der Waage legen muss, um eine Zielstückzahl zu erreichen, bzw. dass die Waage mit dem Leuchtband das Erreichen der Zielstückzahl signalisiert. Die Waage führt so die Interaktion des Bedieners mit der Waage.

In einer Ausführungsform werden sowohl Zielgewicht wie auch Stückzahl und spezifisches Gewicht eines zu wiegenden Produkts über eine Computereinheit an der Waage durch den Bediener eingegeben. Die Computereinheit ist zum Beispiel ein All-in-One PC, der auch als Touchscreen zur Bedienung der Waage dient. Für die Erfindung ist es jedoch unerheblich, auf welchem spezifischen Weg diese Daten der Steuereinheit zur Verfügung gestellt werden.

In einer Ausführungsform umfasst die Waage einen Drucker. Der Drucker rollt Papier, insbesondere Thermodirekt-Papier, mit einer motorisch angetriebenen Druckwalze von einer Endlosrolle ab und führt es einem Druckkopf zum Thermodirektdruck zu. Der Drucker umfasst einen Sensor, der die Länge des verbrauchten Papiers ermittelt. In einer Ausführungsform ermittelt die Steuerung der Druckwalze die Länge des verbrauchten Papiers, da die Anzahl Umdrehungen der Druckwalze in der Steuerung ermittelbar ist und der Durchmesser der Druckwalze ein bekannter Parameter ist. Die Steuereinheit ermittelt die Differenz aus der auf der Endlosrolle ursprünglich vorhandenen Papierlänge abzüglich der Länge des verbrauchten Papiers seit dem letzten Papierrollenwechsel. Das entspricht dem noch auf der Endlosrolle verbleibenden Papiervorrat. Die Zustandsmaschine verbleibt im zweiten Zustand, solange die Differenz größer einem Schwellwert ist. Das heißt, ist noch Papier auf der Rolle, verbleibt die Zustandsmaschine im zweiten Zustand. Die Zustandsmaschine schaltet in den ersten Zustand, wenn die Differenz unter einen Schwellwert sinkt. Dieser Schwellwert gibt an, dass der Papiervorrat auf der Endlosrolle aufgebraucht oder annähernd aufgebraucht ist und der Bediener eine neue Papierrolle einlegen sollte. Die Zustandsmaschine befindet sich dann im ersten Zustand.

In einer Ausführungsform, umfasst die Steuereinheit einen Empfänger, der zum Empfang von Daten von einer Computereinheit ausgelegt ist. Die Zustandsmaschine der Steuereinheit geht vom zweiten Zustand in den ersten Zustand über, wenn der Empfänger von der Computereinheit ein Signal empfängt, mit dem die Notwendigkeit eines Softwareupdates angegeben wird.

In einer Ausführungsform umfasst die Steuereinheit einen Empfänger, der zum Empfang von Daten von einer Computereinheit ausgelegt ist. Die Zustandsmaschine der Steuereinheit geht vom zweiten Zustand in den ersten Zustand über, wenn der Empfänger von der Computereinheit ein Signal empfängt, dass sich ein Bediener mit seiner Bedienerkennung an der Computereinheit zum Bedienverkauf angemeldet hat. Die Zustandsmaschine der Steuereinheit geht vom ersten Zustand in den zweiten Zustand über, wenn der Empfänger von der Computereinheit ein Signal empfängt, dass sich ein Bediener mit seiner Bedienerkennung an der Computereinheit abgemeldet hat. Die Computereinheit ist zum Beispiel ein All-in-One PC, der auch als Touchscreen zur Bedienung der Waage dient. Für die Erfindung ist es jedoch unerheblich, auf welchem spezifischen Weg diese Daten der Steuereinheit zur Verfügung gestellt werden.

In einer Ausführungsform wechselt die Zustandsmaschine der Steuereinheit vom zweiten Zustand in den ersten Zustand, wenn der durch die Wägezelle gemessene Gewichtswert eine Überlast der Wägezelle darstellt. Der Bediener kann dann umgehend das Produkt von der Lastplatte entfernen, um eine mögliche Beschädigung der Waage und insbesondere der Wägezelle zu vermeiden.

In einer Ausführungsform befindet sich die Zustandsmaschine der Steuereinheit im zweiten Zustand, wenn die Wägezelle eine Anzahl Wiegevorgänge pro Zeiteinheit ausführt, die über einem in der Steuereinheit abgespeicherten Schwellwert liegt. Die Zustandsmaschine der Steuereinheit befindet sich in einem ersten Zustand, wenn die Wägezelle eine Anzahl Wiegevorgänge pro Zeiteinheit ausführt, die unter dem Schwellwert liegt. Die Zustandsmaschine überwacht somit die Geschwindigkeit, mit der ein Bediener mit der Waage interagiert, insbesondere wie viele Wiegevorgänge ein Bediener pro Zeiteinheit durchführt. Ein Wiegevorgang wird zum Beispiel dann erkannt, wenn die Wägezelle einen Gewichtswert erfasst und danach der Gewichtswert auf den Wert Null bzw. auf die Vorlast von Lastplatte und Lastkreuz zurückgeht.

In einer Ausführungsform befindet sich die Zustandsmaschine in dem ersten Zustand, wenn der durch die Wägezelle gemessene Gewichtswert vom Zielgewicht nach unten abweicht. Die Zustandsmaschine befindet sich in einem dritten Zustand befindet, wenn der durch die Wägezelle gemessene Gewichtswert vom Zielgewicht nach oben abweicht. Die Steuereinheit beaufschlagt das Leuchtband gepulst mit einer Spannung, wenn sich die Zustandsmaschine in einem ersten Zustand befindet. In diesem Fall haben die Spannungspulse eine erste Frequenz. Die Steuereinheit beaufschlagt das Leuchtband gepulst einer Spannung, wenn sich die Zustandsmaschine in einem dritten Zustand befindet. In diesem Fall haben die Spannungspulse eine zweite Frequenz. Die erste Frequenz und die zweite Frequenz unterscheiden sich. In einer Ausführungsform ist die erste Frequenz kleiner als die zweite Frequenz. Das führt dazu, dass das Leuchtband langsam blinkt, wenn das Zielgewicht unterschritten ist. Das Leichtband blinkt schnell, wenn das Zielgewicht überschritten ist. Das Leuchtband leuchtet permanent, wenn das Zielgewicht erreicht ist. So ermöglicht die Waage dem Bediener eine geführte Mensch-Maschine-Interaktion, indem der Bediener aufgrund der Ansteuerung des Leuchtbandes durch die Steuereinheit und des daraus hervorgerufenen schnellen bzw. langsamen Blinkens weitere Produkte, zum Beispiel Wurstscheiben, auf die Lastplatte auflegen kann oder Produkte, zum Beispiel Wurstscheiben, von der Lastplatte entnehmen kann, bis der Differenzwert, der in der Steuereinheit zwischen Zielgewicht und gemessenem Gewichtswert gebildet wird, einen Schwellwert unterschreitet und das Zielgewicht deshalb als erreicht gilt. Dies führt dazu, dass die Steuereinheit in einen Betriebsmodus schaltet, in dem eine permanente Spannung an das Leuchtband durch die Steuereinheit angelegt wird. Gleiches gilt für Stückgut, wenn der Bediener eine gewisse Anzahl von Produkten mit der Lastplatte separieren, das heißt zählen soll. Bei einer großen Zahl von gewünschten Produkten, zum Beispiel 100 Schrauben, wird durch das spezifische Gewicht einer Schraube in der Steuereinheit ein Zielgewicht errechnet und die Waage ermöglicht dem Bediener eine geführte Mensch-Maschine-Interaktion, um eine Menge aus einer Anzahl eines Stückgutes, zum Beispiel 100 Schrauben, auf der Lastplatte zu bilden.

In einer Ausführungsform umläuft das Leuchtband das Gehäuse einmal, insbesondere umläuft das Leuchtband das Gehäuse im oberen Bereich seiner Seitenwände einmal, wobei zwischen Anfang und Ende des Leuchtbandes ein, im Verhältnis zur Länge des Leuchtbandes, kleiner Abstand sein kann. Dabei umfasst die Waage eine Lastplatte, die auf dem Lastkreuz abgelegt ist. Dabei führen die äußeren Ränder der Lastplatte über das Lastkreuz und über die Oberkante des Gehäuses nach unten, so dass die Lastplatte wie ein Deckel auf der Oberseite des Gehäuses schwebt. In einer Ausführungsform befindet sich das Leuchtband im oberen Bereich der Seitenwände des Gehäuses, jedoch unterhalb der Ränder der Lastplatte. In einer Ausführungsform ist das Leuchtband am oberen Rand des Gehäuses derart angebracht, dass es von den überstehenden Rändern der Lastplatte verdeckt wird. In diesem Fall leuchtet das Licht des Leuchtbandes diffus unter den nach unten stehenden Rändern der Lastplatte hervor.

In einer Ausführungsform sind in dem flexiblen Trägermaterial des Leuchtbandes elektrische Leitungen für die Ansteuerung der LED-Leuchtmittel integriert.

In einer Ausführungsform erzeugen die LED-Leuchtmittel Licht im Wellenlängenbereich von 230 nm bis 500 nm. Der Träger mit den LED-Leuchtmitteln ist mit Phosphor überzogen. Insbesondere ist das Leuchtband auf der Seite, auf der die LED-Leuchtmittel angebracht sind, mit Phosphor überzogen. Phosphor wandelt das blaue oder ultraviolette Licht der LED-Leuchtmittel in weißes Licht.

Es ist insbesondere zu beachten, dass nicht jedes der LED-Leuchtmittel einzeln und separat mit Phosphor überzogen ist bzw. wurde, sondern dass die LED-Leuchtmittel zuerst auf dem Träger montiert werden und dann die ganze Seite des Trägers mit Phosphor überzogen wird. So kann die Dichte der LED-Leuchtmittel pro Länge des Leuchtbandes deutlich erhöht werden und es kommt zu einem sehr homogenen Leuchteffekt. Dies führt auch dazu, dass die Ausleuchtung durch das Licht der LED-Leuchtmittel im Bezug zur Ebene des Leuchtbandes ca. 170° beträgt, das heißt, das Licht ist auch aus sehr spitzen Winkeln wahrnehmbar.

In einer Ausführungsform weist der flexible Träger auf der den LED-Leuchtmitteln gegenüberliegenden Seite eine Schicht aus Klebematerial auf. In einer Ausführungsform handelt es sich um eine Schicht aus wärmeleitendem Klebematerial. Das Leuchtband ist mit dem Klebematerial am Gehäuse angebracht, insbesondere angeklebt. Die durch die LED-Leuchtmittel entstehende Hitze wird über die Schicht aus Klebematerial, insbesondere über das wärmeleitende Klebematerial, an das Gehäuse abgegeben.

Das Klebematerial haftet dabei auf einer Fläche aus unbeschichtetem und/oder beschichtetem Metallguss, sodass das Gehäuse an der Stelle, an der das Leuchtband angeklebt wird, beschichtet oder unbeschichtet sein kann.

In einer Ausführungsform ist das Leuchtband mit der Steuereinheit elektrisch verbunden. Das Leuchtband wird von der Steuereinheit mit einer Gleichspannung im Bereich von 6°Volt bis 36°Volt, insbesondere 12°Volt oder 24°Volt, angesteuert.

In einer Ausführungsform umfasst das Gehäuse eine Aussparung oder eine einseitige Aussparung, die im oberen Gehäusebereich an der Außenseite des Gehäuses umlaufend angebracht ist, in die das Leuchtband eingeklebt ist. Unter Aussparung ist dabei eine Vertiefung in der Gehäusewand zu verstehen in der Form einer Rille. Eine einseitige Aussparung meint eine Kante, die zum Beispiel in einer schräg verlaufenden Gehäusewand vorhanden ist. Die Kante bildet eine Vertiefung, deren hinteres Ende zur Aufnahme des Leuchtbandes eine vertikale Ebene ist.

In einer Ausführungsform umfasst die Waage einen Diffusor, der außen am Gehäuse angebracht ist und die Aussparung abdeckt. Der Diffusor sorgt für eine Streuung des Lichtes der LED-Leuchtmitte, sodass nicht mehr zu erkennen ist, dass es sich um diskrete Lichtquellen handelt, sondern dass der Eindruck entsteht, es würde sich um eine ausgedehnte homogene Lichtmittel handeln. Außerdem sorgt der Diffusor dafür, dass das Leuchtband aus jedem Betrachtungswinkel gleich hell wirkt. Der Diffusor verstärkt den Effekt des Phosphors beziehungsweise des Silikons.

In einer Ausführungsform besteht der Diffusor aus einem transluzenten Material. In einer Ausführungsform handelt es sich bei dem transluzenten Material um ein transluzentes Polycarbonat.

In einer Ausführungsform umfasst der Diffusor auf seiner Außenseite eine Strukturierung. Die Strukturierung macht den Diffusor von der Außenseite in Richtung Gehäuse blickdicht. Hingegen ist der Diffusor von der Gehäuseseite nach außen transluzent.

In einer Ausführungsform ist der Diffusor als Ring ausgebildet. Der Ring hat die Abmessungen des Gehäuses im Bereich der Aussparung. Der Ring ist formschlüssig an dem Gehäuse über der Aussparung angebracht. Insbesondere ist der Ring mit einem Rastmechanismus angebracht. In einer Ausführungsform deckt der Diffusor die Aussparung ab. In einer Ausführungsform ist der Diffusor mit dem Gehäuse verklebt oder verschraubt.

In einer Ausführungsform ist die Distanz zwischen den LED-Leuchtmitteln und der Innenseite des Diffusors kleiner 3°mm. In einer Ausführungsform ist die Distanz zwischen den LED-Leuchtmitteln und der Innenseite des Diffusors kleiner 1°mm.

Einige Ausführungsformen der Erfindung sind in den Zeichnungen beispielhaft gezeigt und nachfolgend beschrieben. Es zeigen, jeweils in schematischer Darstellung:
- Fig. 1: Eine erfindungsgemäße Ladenwage in einer ersten Ausführungsform,
- Fig. 2: Eine erfindungsgemäße Ladenwage in einer zweiten Ausführungsform,
- Fig. 3: Einen Ausschnitt einer erfindungsgemäßen Ladenwaage, und
- Fig. 4: Eine Darstellung der Steuereinheit mit der Zustandsmaschine der Ladenwaage.

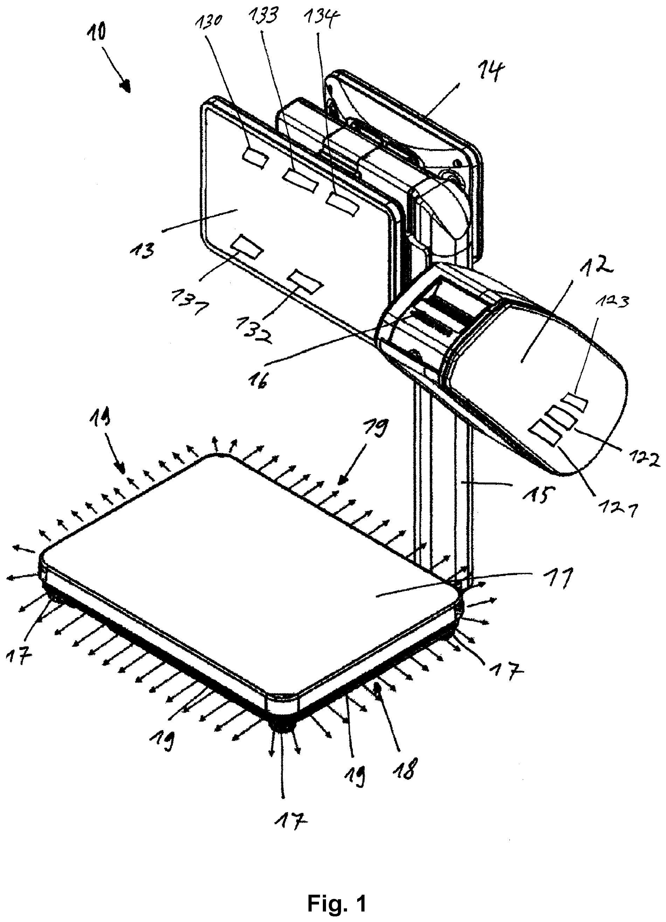

Fig. 1 zeigt eine erfindungsgemäße Waage 10 nach einer ersten Ausführungsform. Die Waage umfasst einen Wägemodul mit einem Gehäuse 18, in dem eine Wägezelle untergerbacht ist. Die Wägezelle trägt ein Lastkreuz, das seinerseits eine Lastplatte 11 trägt. Die Lastplatte 11 hat einen nach unten stehenden Rand, der über die obere Kante des Gehäuses 18 ragt. Am Wägemodul ist ein Stativ 15 befestigt, das einen Drucker 12 mit einer Etikettenausgabe 16 trägt. Der Drucker 12 hat einen Sender 121, der die Papierlänge übermittelt, die sich auf einer vollen Papierrolle befindet. Der Drucker 12 hat einen Sender 123, der den aktuellen Papierverbrauch, der durch die Drehung einer Druckwalze bestimmt wird, übermittelt. Der Drucker 12 hat einen Sender 122, der ein Resetsignal sendet, wenn eine neue Papierrolle in den Drucker 12 eingelegt wird. eingelegt wird. Das Stativ 15 trägt ferner ein Bedienerdisplay 13, das als Touchscreen ausgebildet ist, und ein dem Bedienerdisplay 13 gegenüberliegendes Kundendisplay 14. Das Bedienerdisplay 13 ist ein All-in-One PC und umfasst eine Computereinheit, die die computerimplementierten Funktionen 131 oder Bediener-Eingaben 130, 132, 133, 134 der Waage sicherstellt. Das Wägemodul ruht auf vier in seinen Ecken angebrachten Füßen 17. An äußeren Rand des Gehäuses 18 ist umlaufend ein Leuchtband 19 angebracht, das von einer Steuereinheit in Abhängigkeit eines technischen Zustands der Waage angesteuert wird.

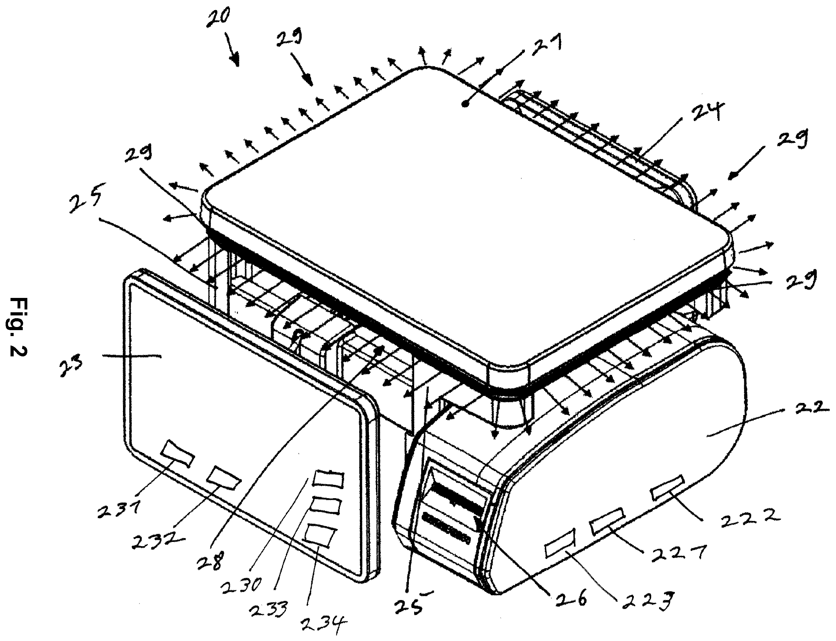

Fig. 2 zeigt eine erfindungsgemäße Waage 20 nach einer zweiten Ausführungsform. Die Waage umfasst einen Wägemodul mit einem Gehäuse 28, in dem eine Wägezelle untergerbacht ist. Die Wägezelle trägt ein Lastkreuz, das seinerseits eine Lastplatte 21 trägt. Die Lastplatte 21 hat einen nach unten stehenden Rand, der über die obere Kante des Gehäuses 28 ragt. Das Wägemodul ruht auf einem Gestell 25, das einen Drucker 22 mit einer Etikettenausgabe 26 trägt. Der Drucker 22 hat einen Sender 221, der die Papierlänge übermittelt, die sich auf einer vollen Papierrolle befindet. Der Drucker 22 hat einen Sender 223, der den aktuellen Papierverbrauch, der durch die Drehung einer Druckwalze bestimmt wird, übermittelt. Der Drucker 22 hat einen Sender 222, der ein Resetsignal sendet, wenn eine neue Papierrolle in den Drucker 22 eingelegt wird. eingelegt wird. Das Gestell 25 trägt ferner ein Bedienerdisplay 23, das als Touchscreen ausgebildet ist, und ein dem Bedienerdisplay 23 gegenüberliegendes Kundendisplay 24. Das Bedienerdisplay 23 ist ein All-in-One PC und umfasst eine Computereinheit, die die computerimplementierten Funktionen 230 oder Bediener-Eingaben 230, 232, 233, 234 der Waage sicherstellt. An äußeren Rand des Gehäuses 28 ist umlaufend ein Leuchtband 29 angebracht, das von einer Steuereinheit in Abhängigkeit eines technischen Zustands der Waage angesteuert wird.

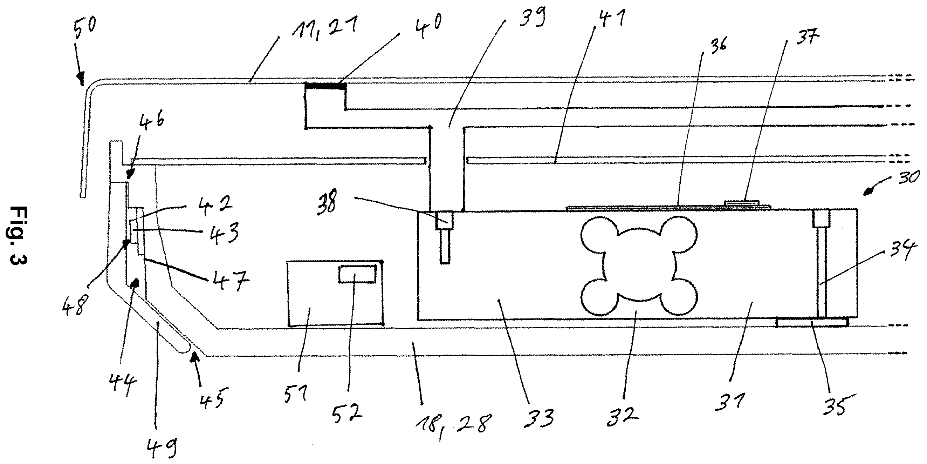

Fig. 3 zeigt einen Schnitt durch das Gehäuse 18, 28 einer Waage 10, 20. Das Gehäuse 18, 28 ist ein Metallgussgehäuse und kann komplexe Formen annehmen. Im Inneren des Gehäuses 18, 28 ist auf einem Sockel 35 eine Wägezelle 30 mit Schrauben 34 verschraubt. Die Wägezelle 30 umfasst einen mit dem Gehäuse 18, 28 verschraubten festen Abschnitt 31, einen Verformungsabschnitt 32 und einen beweglichen Abschnitt 33, auf dem ein Lastkreuz 39 mit einer Befestigung 38 angebracht ist. Das Lastkreuz 39 trägt die Lastplatte 11, 21 der Waage, wobei zwischen Lastkreuz 39 und Lastplatte 11, 21 Gummipuffer 40 angebracht sind. Die Lastplatte 11, 21 umfasst an ihren Rändern eine Biegung 50, so dass die Lastplatte 11, 21 seitlich nach unten über die oberen Ränder des Gehäuses 18, 28 ragt. Die Gewichtskraft eines Produkts auf der Lastplatte 11, 21 und auch die Gewichtskraft von Lastkreuz 39 und Lastplatte 11, 21 selbst wirken so auf den beweglichen Abschnitt 33 der Wägezelle 30. Dies führt zu einer mechanischen Verformung des Verformungsabschnitts 32, welche über auf dem Verformungsabschnitt 32 angebrachte Dehnungsmesstreifen 36 gemessen wird. Die gemessene Verformung wird mit einer Auswerteeinheit 37 bestimmt und in einen Gewichtswert des Produkts umgerechnet. Der Innenraum des Gehäuses 18, 28, in dem sich die Wägezelle 30 und auch eine Steuereinheit 51 und ggf. weitere Komponenten der Waage wie Netzteil und ähnliches befinden, ist mit einer Abdeckung 41 abgedeckt.

Das Gehäuse 18, 28 besteht aus einer Bodenplatte und vier nach oben ragenden Seitenwänden. Das Gehäuse ist aus Metallguss und somit einstückig ausgebildet. Der Übergang zwischen Bodenplatte und Seitenwänden ist angeschrägt. Im oberen Bereich der Seitenwände ist eine Aussparung 44 angebracht, so dass eine vertikal stehende Außenwand 47 an den Seitenwänden des Gehäuses 18, 28 etwas zurückversetzt ist. An dieser vertikal stehenden Außenwand 47 ist der Träger 42 des Leuchtbandes 19, 29 festgeklebt. Der Träger 42 ist aus flexiblem Material gebildet und kann somit auch um die Ecken des Gehäuses 18, 28 in der Aussparung 44 geführt werden. Flexibel meint in diesem Zusammenhang, dass der Träger 42 zumindest senkrecht zur Ebene, in der der Träger 42 verläuft, verbogen werden kann, nicht gezwungenermaßen auch in der Ebene des Trägers 42 selbst. Auf dem Träger 42 sind LED-Leuchtmittel 43 abgebracht. Die LED-Leuchtmittel 43 können in Längsrichtung des Trägers 42 mit einer Dichte von bis zu zehn LED-Leuchtmittel 43 pro cm angebracht sein. Träger 42 und LED-Leuchtmittel 43 sind auf der Seite der LED-Leuchtmittel mit einer Schutzschicht 48 aus Silikon oder Phosphor abgedeckt. Dabei ist die Schutzschicht 48 nicht nur auf den LED-Leuchtmitteln 43 selbst vor deren Montage auf dem Träger 42 angebracht, sondern wird nach der Montage der LED-Leuchtmittel 43 auf dem Träger 42 über den Trägers 42 und die LED-Leuchtmittel 42 angebracht. So kann eine höhere Dichte der LED-Leuchtmittel 43 auf dem Träger 42 erreicht werden und der Abstrahlwinkel für homogenes Licht jedes LED-Leuchtmittels 43 erhöht sich auf ca. 170°. Eine Schutzschicht 48 aus Silikon wird aufgetragen, wenn die LED-Leuchtmittel 43 Licht im Wellenlängenbereich von 450°nm bis 500°nm, 500°nm bis 570°nm beziehungsweise 610°nm bis 760°nm erzeugen und die unterschiedlichen LED-Leuchtmittel 43 in regelmäßigen Anordnungen auf dem Träger 42 angeordnet sind. Hierdurch kann das Leuchtband 19, 29 in RGB-Farben über die Steuereinheit 51 zum Leuchten gebracht werden. Eine Schutzschicht 48 aus Phosphor wird aufgetragen, wenn die LED-Leuchtmittel 43 Licht im Wellenlängenbereich von 230 nm bis 500 nm (ultraviolettes bis blaues Licht) abgeben. Durch die Schutzschicht 48 aus Phosphor wird dieses Licht für den Bediener als weißes Licht sichtbar.

Die Aussparung 44 mit Träger 42, LED-Leuchtmitteln 43 und Schutzschicht 48 ist durch einen Diffusor 49 abgedeckt. Der Diffusor 49 bietet einen mechanischen Schutz des Leuchtbandes 19, 29 und bricht das Licht gleichzeitig, so dass das Leuchtband 19, 29 wie eine homogene Lichtquelle wirkt. Dazu kann der Diffusor 49 auf seiner äußeren Fläche strukturiert, das heißt oberflächenbearbeitet sein. Der Effekt, dass das Leuchtband 19, 29 wie eine homogene Lichtquelle wirkt, wird durch die hohe Dichte an LED-Leuchtmitteln 43 und durch die gemeinsame Schutzschicht 48 aus Silikon oder Phosphor auf den LED-Leuchtmitteln 43 hervorgerufen und durch den Diffusor 49 und die außenseitige Strukturierung des Diffusors 49 verstärkt bzw. vervollständigt. Der Diffusor 49 liegt an Flächen 45, 46 des Gehäuses 18, 28 oberhalb und unterhalb der Aussparung 44 an und ist an diese Flächen 45, 46 geklebt, mit einer Rastverbindung daran verrastet oder verschraubt. Der Diffusor 49 ist ein ringförmiges Bauteil, das von unten über das Gehäuse 18,28 geschoben wird und formschlüssig auf die Seitenwände des Gehäuses 18, 28 passt. Der Diffusor 49 ist aus transluzentem Material, insbesondere aus transluzentem Polycarbonat, hergestellt.

Die Steuereinheit 51 umfasst eine Zustandsmaschine 52, die mindestens einen technischen Zustand der Waage abbildet. Die Steuereinheit steuert das Leuchtband 19, 29 aufgrund des Zustandes der Zustandsmaschine 52.

Der technische Zustand, der durch die Zustandsmaschine abgebildet wird, kann ein Papiervorrat in einem Drucker sein, eine Differenz zu einem Sollgewicht, die durch das durch die Wägezelle ermittelte Gewicht und das Sollgewicht gebildet wird, ein veralteter Softwarestand, der durch Updates aktualisiert werden muss, eine Geschwindigkeit verschiedener Gewichtserfassungsschritte oder über ein Bedienerdisplay eingegebener Bearbeitungsschritte oder dass sich ein Bediener korrekt an der Waage über das Bedienerdisplay identifiziert hat. Je nachdem, in welchem Zustand sich die Zustandsmaschine aufgrund verschiedener Eingangsparameter von Wägezelle, Sensoren oder der Waagensteuerung befindet, kann eine Ansteuerung des Leuchtbandes zum Beispiel in verschiedenen Farben (rot, gelb, grün) bei einem RGB-Leuchtband oder als leuchtend bzw. blinkend bei einem monochromen Leichtband erfolgen.

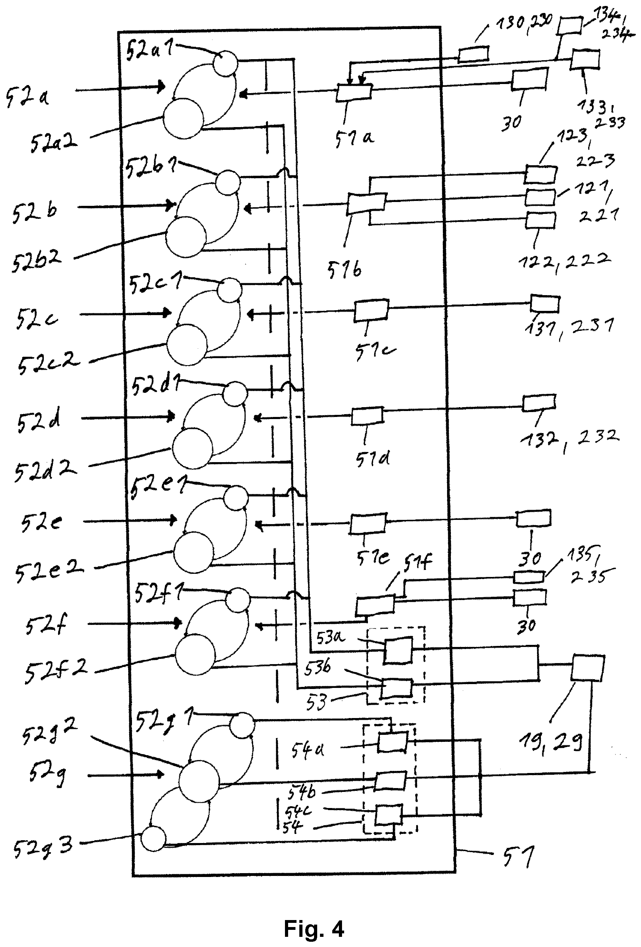

Fig. 4 zeigt eine schematische Darstellung der Steuereinheit 51 und in der Steuereinheit realisierten Zustandsmaschine 52. Dabei sind in Fig. 4 verschiedene Zustandsmaschinen 52a, 52b, 52c, 52d, 52e, 52f, 52g gezeigt, die alle oder auch nur einige davon in einer Steuereinheit 51 einer erfindungsgemäßen Waage 10, 20 realisiert sein können. Jeder Zustandsmaschine 52a, 52b, 52c, 52d, 52e, 52f, 52g ist ein Steuermodul 51a, 51b, 51c, 51d, 51e, 51f zugeordnet, das mit der entsprechenden Zustandsmaschine 52a, 52b, 52c, 52d, 52e, 52f, 52g interagiert und ein Teil der Steuereinheit 51 ist.

Das erste Steuermodul 51a empfängt von einer Eingabeeinrichtung der Waage 10, 20, zum Beispiel dem Bedienerdisplay 13, 23, ein Zielgewicht 130, 230. Alternativ empfängt das erste Steuermodul 51a von eine Eingabevorrichtung 13, 23 der Waage 10, 20 eine Zielstückzahl 134, 234 von Produkten und ein spezifisches Gewicht 133, 233 pro Produkt. Aus der Zielstückzahl 134, 234 und dem spezifischen Gewicht 133, 233 pro Produkt errechnet die erste Steuermodul 51a ein Zielgewicht. Das erste Steuermodul 51a kann dabei aus dem Zielgewicht einen Gewichtsbereich ermitteln, der Toleranzen einschließt, wobei dann der gesamte Gewichtsbereich als Zielgewicht angesehen wird. Des Weiteren empfängt das erste Steuermodul 51a von der Wägezelle 30 ermittelte Gewichtswerte. Entspricht ein von der Wägezelle 30 ermittelter Gewichtswert dem Zielgewicht, so schaltet bzw. verbleibt die erste Zustandsmaschine 52a in einem zweiten Zustand 52a2. Entspricht das von der Wägezelle 30 ermittelte Gewicht nicht dem Zielgewicht, so schaltet bzw. verbleibt die erste Zustandsmaschine 52a in den ersten Zustand 52a1. Die Zustandsübergänge zwischen dem ersten Zustand 52a1 und dem zweiten Zustand 52a2 sind in der Zeichnung angedeutet, wobei das Verbleiben im entsprechenden Zustand aus Gründen der Übersichtlichkeit nicht separat angedeutet ist.

Das zweite Steuermodul 51b empfängt von einem Drucker 12, 22 eine Papierlänge 121, 221, die auf einer Endlosrolle aus Thermodirektpapier vorhanden ist, sowie ein Resetsignal 122, 222, das aussagt, dass eine volle Thermodirektrolle neu in den Drucker eingelegt worden ist. Fortlaufend empfängt das zweite Steuermodul 51b von dem Drucker 12, 22 eine Information 123, 223, wieviel Papier über die motorisch angetriebene Druckwalze dem Druckkopf zugeführt wird. Dies entspricht dem verbrauchten Thermodirekt-Papier. Das zweite Steuermodul 51b bildet die Differenz aus der Papierlänge 121, 221 auf der Endlosrolle sowie dem verbrauchten Papier 123, 223. Ist diese Differenz kleiner als ein Schwellwert, insbesondere Null, das heißt, der Papiervorrat der Etikettenrolle ist aufgebraucht, schaltet das zweite Steuermodul 51b die zweite Zustandsmaschine 52b in den ersten Zustand 52b1. Ist diese Differenz größer als ein Schwellwert, insbesondere größer Null, das heißt, das Papier der Endlosetikettenrolle ist noch nicht aufgebraucht, so verbleibt die zweite Zustandsmaschine 52b im zweiten Zustand 52b2. Wird eine Papierrolle aufgefüllt und empfängt das zweite Steuermodul 51b ein entsprechendes Resetsignal 122, 222 vom Drucker 12, 22, so verbringt das zweite Steuermodul 51b die zweite Zustandsmaschine 52b in den zweiten Zustand 52b2.

Das dritte Steuermodul 51c empfängt von einer Computereinheit der Waage 10, 20, die zum Beispiel im Bedienerdisplay 13, 23 der Waage als All-in-On Computer intergiert ist, eine Aufforderung 131, 231 Updates für die Software zu aktualisieren. Das dritte Steuermodul 51c veranlasst die dritte Zustandsmaschine 52c in den ersten Zustand 52c1 überzugehen. Empfängt das dritte Steuermodul 51c von der Waage 10, 20, dass die Updates installiert wurden, veranlasst das dritte Steuermodul 51c die dritte Zustandsmaschine 52c in den zweiten Zustand 52c2 überzugehen.

Das vierte Steuermodul 51d empfängt von einer Computereinheit der Waage 10, 20, die zum Beispiel im Bedienerdisplay 13, 23 der Waage als All-in-On Computer intergiert ist, eine Information 132, 232, ob aktuell ein Bediener zum Bedienverkauf an der Waage angemeldet ist. Hat sich ein Bediener angemeldet, so veranlasst das vierte Steuermodul 51d die vierte Zustandsmaschine 52d in den ersten Zustand 52d1 überzugehen. Empfängt das vierte Steuermodul 51d die Information 132, 232 von der Waage 10, 20, dass der Bediener den Bedienvorgang abgeschlossen hat und die Waage somit wieder für weitere Bediener frei ist, veranlasst das vierte Steuermodul 51d die vierte Zustandsmaschine 52d in den zweiten Zustand 52d2 überzugehen.

Wird die Wägezelle 30 im laufenden Betrieb mit Gegenständen belastet, die über das zulässige Höchstgewicht der Wägezelle 30 hinausgehen, so stellt dies eine Überlastsituation dar. In diesem Fall gibt die Wägezelle 30 ein entsprechendes Warnsignal aus. Das fünfte Steuermodul 51e empfängt von der Wägezelle 30 ein Warnsignal, das eine Überlastsituation darstellt und veranlasst die fünfte Zustandsmaschine 52e in den ersten Zustand 52e1 überzugehen. Empfängt das fünfte Steuermodul 51e kein Überlastsignal von der Wägezelle 30 mehr, so veranlasst das fünfte Steuermodul 51e die fünfte Zustandsmaschine 52e in den zweiten Zustand 52d2 überzugehen.

Das sechste Steuermodul 51f empfängt von einer Computereinheit der Waage 10, 20, die zum Beispiel im Bedienerdisplay 13, 23 der Waage als All-in-On Computer intergiert ist, einen Schwellwert 135, 235, wie viele Wiegungen pro Zeiteinheit ein Bediener vornehmen muss. Außerdem empfängt das sechste Steuermodul 51f fortlaufend die Wiegungen von der Wägezelle 30. Das sechste Steuermodul errechnet daraus, ob die notwendige Anzahl Wiegungen pro Zeiteinheit vom Bediener erreicht wird. Das sechste Steuermodul 51f verbringt die sechste Zustandsmaschine 52f in den ersten Zustand 52f1, falls der Schwellwert 135, 235 nicht erreicht wird. Die sechste Steuermodul 51f verbringt die sechste Zustandsmaschine 52f in den zweiten Zustand 52f2, falls der Schwellwert 135, 235 erreicht oder überschritten ist.

Das siebte Steuermodul empfängt von einer Eingabeeinrichtung der Waage 10, 20, zum Beispiel dem Bedienerdisplay 13, 23, ein Zielgewicht. Alternativ empfängt das siebte Steuermodul von eine Eingabevorrichtung 13, 23 der Waage 10, 20 eine Zielstückzahl von Produkten und ein spezifisches Gewicht pro Produkt. Aus der Zielstückzahl und dem spezifischen Gewicht pro Produkt errechnet die siebte Steuermodul ein Zielgewicht. Das siebte Steuermodul kann dabei aus dem Zielgewicht einen Gewichtsbereich ermitteln, der Toleranzen einschließt, wobei dann der gesamte Gewichtsbereich als Zielgewicht angesehen wird. Das siebte Steuermodul sowie die vom siebten Steuermodul empfangenen Daten wie Zielgewicht, Zielstückzahl oder spezifisches Gewicht pro Produkt sind in Fig. 4 aus Gründen der Übersichtlichkeit nicht dargestellt. Eine Darstellung wäre analog zur Darstellung des ersten Steuermoduls 51a. Des Weiteren empfängt das siebte Steuermodul von der Wägezelle 30 ermittelte Gewichtswerte. Entspricht ein von der Wägezelle 30 ermittelter Gewichtswert dem Zielgewicht, so schaltet bzw. verbleibt die siebte Zustandsmaschine 52g in einem zweiten Zustand 52g2. Unterschreitet das von der Wägezelle 30 ermittelte Gewicht das Zielgewicht, so schaltet bzw. verbleibt die siebte Zustandsmaschine 52g in den ersten Zustand 52g1. Überschreitet das von der Wägezelle 30 ermittelte Gewicht das Zielgewicht, so schaltet bzw. verbleibt die siebte Zustandsmaschine 52g in den dritten Zustand 52g3.

Die Steuervorrichtung 51 umfasst Controller 53, 54, die das Leuchtband 19, 29 ansteuern und mit Spannung versorgen. Dabei ist vorab eine Auswahl zu treffen, welche der Zustandsmaschinen 52a, 52b, 52c, 52d, 52e, 52f den Controller zu einem Zeitpunkt mit einem Eingangssignal versorgt und welcher Controller 53, 54 das Leuchtband 19, 29 ansteuert. Das Leuchtband 19, 29 kann zu einem Zeitpunkt nur den Zustand einer Zustandsmaschine wiedergeben. Diese Auswahl ist durch den Bediener im Bedienerdisplay 13, 23 zu treffen. Die erste bis sechste Zustandsmaschine 52a, 52b, 52c, 52d, 52e, 52f sind mit dem ersten Controller 53 verbunden. Die siebte Zustandsmaschine ist mit dem zweiten Controller 54 verbunden.

Für den Fall, dass das Leuchtband 19, 29 ein Leuchtband 19, 29 mit Leuchtmitteln 43 im Wellenlängenbereich von 230 nm bis 500 nm ist (monochromes Leuchtband), gilt:
Steuert der erste Controller 53 das Leuchtband 19, 29 an und befindet sich die ausgewählte Zustandsmaschine 52a, 52b, 52c, 52d, 52e, 52f in einem ersten Zustand 52a1, 52b1, 52c1, 52d1, 52e1, 52f1, so wird das Leuchtband durch den Controller 53a mit einer gepulsten Spannung beaufschlagt. Das Leuchtband 19, 29 blinkt. Befindet sich die ausgewählte Zustandsmaschine 52a, 52b, 52c, 52d, 52e, 52f in einem zweiten Zustand 52a2, 52b2, 52c2, 52d2, 52e2, 52f2, so wird das Leuchtband durch den Controller 53b mit einer permanenten Spannung beaufschlagt. Das Leuchtband 19, 29 leuchtet.

Steuert der zweite Controller 54 das Leuchtband 19, 29 an und befindet sich die siebte Zustandsmaschine in einem ersten Zustand 52g1, so wird das Leuchtband durch den Controller 54a mit einer gepulsten Spannung einer ersten Frequenz beaufschlagt. Das Leuchtband 19, 29 blinkt langsam. Befindet sich die siebte Zustandsmaschine in einem dritten Zustand 52g3, so wird das Leuchtband durch den Controller 54c mit einer gepulsten Spannung einer zweiten Frequenz beaufschlagt. Das Leuchtband 19, 29 blinkt schnell. Befindet sich die siebte Zustandsmaschine 52g in einem zweiten Zustand 52g2, so wird das Leuchtband durch den Controller 54b mit einer permanenten Spannung beaufschlagt. Das Leuchtband 19, 29 leuchtet.

Für den Fall, dass das Leuchtband 19, 29 ein Leuchtband 19, 29 mit einer Gruppe von zweiten LED-Leuchtmittel 43 mit einem Wellenlängenbereich von 500°nm bis 570°nm (grünes Licht) und einer Gruppe von dritten LED-Leuchtmittel 43 mit einem Wellenlängenbereich 610°nm bis 760°nm (rotes Licht) ist, gilt:
Steuert der erste Controller 53 das Leuchtband 19, 29 an und befindet sich die ausgewählte Zustandsmaschine 52a, 52b, 52c, 52d, 52e, 52f in einem ersten Zustand 52a1, 52b1, 52c1, 52d1, 52e1, 52f1, so wird die Gruppe von dritten LED-Leuchtmitteln 43 des Leuchtbandes durch den Controller 53a mit einer permanenten Spannung beaufschlagt. Das Leuchtband 19, 29 leuchtet rot. Befindet sich die ausgewählte Zustandsmaschine 52a, 52b, 52c, 52d, 52e, 52f in einem zweiten Zustand 52a2, 52b2, 52c2, 52d2, 52e2, 52f2, so wird die Gruppe von zweiten LED-Leuchtmitteln 43 des Leuchtbandes durch den Controller 53b mit einer permanenten Spannung beaufschlagt. Das Leuchtband 19, 29 leuchtet grün.

Steuert der zweite Controller 54 das Leuchtband 19, 29 an und befindet sich die siebte Zustandsmaschine in einem ersten Zustand 52f1, so wird die Gruppe von zweiten LED-Leuchtmitteln 43 und die Gruppe von dritten LED-Leuchtmitteln 43 des Leuchtbandes durch den Controller 54a mit einer permanenten Spannung beaufschlagt. Das Leuchtband 19, 29 leuchtet gelb. Befindet sich die siebte Zustandsmaschine in einem dritten Zustand 52f3, so wird die Gruppe von dritten LED-Leuchtmitteln 43 des Leuchtbandes durch den Controller 54c mit einer permanenten Spannung beaufschlagt. Das Leuchtband 19, 29 leuchtet rot. Befindet sich die siebte Zustandsmaschine 52f in einem zweiten Zustand 52f2, so wird die Gruppe von zweiten LED-Leuchtmitteln 43 des Leuchtbandes durch den Controller 53b mit einer permanenten Spannung beaufschlagt. Das Leuchtband 19, 29 leuchtet grün.

Die Funktionen verschiedener in den Zeichnungen gezeigter Elemente, inklusive der Funktionsblöcke, können durch dezidierte Hardware oder durch generische Hardware, die in der Lage ist, Software auszuführen, im Zusammenhang mit der entsprechenden Software, realisiert werden. Falls die Funktionen mittels eines Prozessors zur Verfügung gestellt werden, können sie durch einen einzigen dezidierten Prozessor, einen einzigen geteilten Prozessor oder mehrere generische Prozessoren, die wiederum geteilt sein können, zur Verfügung gestellt werden. Die Funktionen können, ohne Einschränkung, durch einen digital signal processor (DSP), Netzwerk Prozessor, application specific integrated circuit (ASIC), field programmable gate array (FPGA), read only memory (ROM) mit gespeicherter Software, random access memory (RAM), und nichtflüchtige Speicher zur Verfügung gestellt werden.

## Patentansprüche

1. Waage (10, 20), insbesondere Ladenwaage, mit einem Wägemodul, wobei das Wägemodul ein Gehäuse (18, 28) umfasst, in dem eine Wägezelle (30) untergebracht ist, wobei die Wägezelle (30) einen festen Abschnitt (31), einen Verformungsabschnitt (32) und einen beweglichen Abschnitt (33) umfasst, wobei der feste Abschnitt (31) mit dem Gehäuse (18, 28) verbunden ist und der bewegliche Abschnitt (33) ein Lastkreuz (39) mit einer Lastplatte (11, 21) trägt, wobei der Verformungsabschnitt (32) einen Dehnungsmesstreifen (36) zur Messung eines auf die Lastplatte (11, 21) wirkenden Gewichts aufweist, **dadurch gekennzeichnet, dass** an der Außenwand (47) des Gehäuses ein Leuchtband (19, 29) angebracht ist, das im Wesentlichen umlaufend am Gehäuse (18, 28) angebracht ist, und dass die Waage eine Steuereinheit (51) umfasst, die eine Zustandsmaschine (52) umfasst, die mindestens einen technischen Zustand der Waage abbildet, wobei die Steuereinheit (51) das Leuchtband (19, 29) aufgrund des Zustands der Zustandsmaschine (52) ansteuert, und dass die Steuereinheit das Leuchtband gepulst mit einer Spannung beaufschlagt, wenn sich die Zustandsmaschine (52) in einem ersten Zustand (52a1, 52b1, 52c1, 52d1, 52e1, 52f1, 52g1) befindet und permanent mit einer Spannung beaufschlagt, wenn sich die Zustandsmaschine (52) in einem zweiten Zustand (52a2, 52b2, 52c2, 52d2, 52e2, 52f2, 52g2) befindet.

2. Waage, insbesondere Ladenwaage, nach Anspruch 1, **dadurch gekennzeichnet, dass** in einem Speicher in der Steuereinheit ein Zielgewicht hinterlegt ist, und dass die Zustandsmaschine sich in dem zweiten Zustand befindet, wenn der durch die Wägezelle gemessene Gewichtswert dem Zielgewicht entspricht und die Zustandsmaschine sich in dem ersten Zustand befindet, wenn der durch die Wägezelle gemessene Gewichtswert vom Zielgewicht abweicht.

3. Waage, insbesondere Ladenwaage, nach Anspruch 2, **dadurch gekennzeichnet, dass** in einem Speicher in der Steuereinheit eine Zielstückzahl und ein durchschnittliches Gewicht pro Stück hinterlegt ist, und dass die Steuereinheit durch Multiplikation von Zielstückzahl mit dem durchschnittlichen Gewicht pro Stück ein Zielgewicht errechnet.

4. Waage, insbesondere Ladenwaage, nach einem der Ansprüche 1 bis 3, **dadurch gekennzeichnet, dass** die Waage einen Drucker umfasst, der Papier, insbesondere Thermodirekt-Papier, mit einer motorisch angetriebenen Druckwalze von einer Endlosrolle abrollt und einem Druckkopf zum Thermodirektdruck zuführt, und dass der Drucker einen Sensor umfasst, der die Länge des verbrauchten Papiers ermittelt, und dass die Steuereinheit die Differenz aus der auf der Endlosrolle ursprünglich vorhandenen Papierlänge abzüglich der Länge des verbrauchten Papiers seit dem letzten Papierrollenwechsel bildet, und dass die Zustandsmaschine im zweiten Zustand verbleibt, solange die Differenz größer einem Schwellwert ist und die Zustandsmaschine in den ersten Zustand schaltet, wenn die Differenz kleiner dem Schwellwert ist.

5. Waage, insbesondere Ladenwaage, nach einem der Ansprüche 1 bis 4, **dadurch gekennzeichnet, dass** die Steuereinheit einen Empfänger umfasst, der zum Empfang von Daten von einer Computereinheit ausgelegt ist, wobei die Zustandsmaschine der Steuereinheit vom zweiten Zustand in den ersten Zustand übergeht, wenn der Empfänger von der Computereinheit ein Signal empfängt, mit dem die Notwendigkeit eines Softwareupdates angegeben wird.

6. Waage, insbesondere Ladenwaage, nach einem der Ansprüche 1 bis 5, **dadurch gekennzeichnet, dass** die Steuereinheit einen Empfänger umfasst, der zum Empfang von Daten von einer Computereinheit ausgelegt ist, wobei die Zustandsmaschine der Steuereinheit vom zweiten Zustand in den ersten Zustand übergeht, wenn der Empfänger von der Computereinheit ein Signal empfängt, dass sich ein Bediener mit seiner Bedienerkennung an der Computereinheit zum Bedienverkauf angemeldet hat, und dass die Zustandsmaschine der Steuereinheit vom ersten Zustand in den zweiten Zustand übergeht, wenn der Empfänger von der Computereinheit ein Signal empfängt, dass sich ein Bediener mit seiner Bedienerkennung an der Computereinheit abgemeldet hat.

7. Waage, insbesondere Ladenwaage, nach einem der Ansprüche 1 bis 6, **dadurch gekennzeichnet, dass** die Zustandsmaschine der Steuereinheit vom zweiten Zustand in den ersten Zustand wechselt, wenn der durch die Wägezelle gemessene Gewichtswert eine Überlast der Wägezelle darstellt.

8. Waage, insbesondere Ladenwaage, nach einem der Ansprüche 1 bis 7, **dadurch gekennzeichnet, dass** die Zustandsmaschine der Steuereinheit sich im zweiten Zustand befindet, wenn die Wägezelle eine Anzahl Wiegevorgänge pro Zeiteinheit ausführt, die über einem in der Steuereinheit abgespeicherten Schwellwert liegt, und sich die Zustandsmaschine der Steuereinheit in einem ersten Zustand befindet, wenn die Wägezelle eine Anzahl Wiegevorgänge pro Zeiteinheit ausführt, die unter dem Schwellwert liegt.

9. Waage, insbesondere Ladenwaage, nach Anspruch 2 oder 3,
**dadurch gekennzeichnet, dass** sich die Zustandsmaschine sich in dem ersten Zustand befindet, wenn der durch die Wägezelle gemessene Gewichtswert vom Zielgewicht nach unten abweicht und dass sich die Zustandsmaschine in einem dritten Zustand befindet, wenn der durch die Wägezelle gemessene Gewichtswert vom Zielgewicht nach oben abweicht, und dass die Steuereinheit das Leuchtband gepulst mit einer ersten Frequenz mit einer Spannung beaufschlagt, wenn sich die Zustandsmaschine in einem ersten Zustand befindet, und dass die Steuereinheit das Leuchtband gepulst mit einer zweiten Frequenz mit einer Spannung beaufschlagt, wenn sich die Zustandsmaschine in einem dritten Zustand befindet, wobei sich die erste Frequenz und die zweite Frequenz unterscheiden.

10. Waage, insbesondere Ladenwaage, nach Anspruch 9, **dadurch gekennzeichnet, dass** die zweite Frequenz höher ist als die erste Frequenz.

11. Waage, insbesondere Ladenwaage, nach einem der Ansprüche 1 bis 10, **dadurch gekennzeichnet, dass** die LED-Leuchtmittel Licht im Wellenlängenbereich von 230 nm bis 500 nm erzeugen und insbesondere mit Phosphor überzogen sind, wobei insbesondere das Leuchtband auf der Seite, auf der die LED-Leuchtmittel angebracht sind, mit Phosphor überzogen ist.

12. Waage, insbesondere Ladenwaage, nach einem der Ansprüche 1 bis 11, wobei das Leuchtband aus einem flexiblen Träger besteht, auf dem die LED-Leuchtmittel angeordnet sind, wobei der Träger insbesondere eine bis zehn LED-Leuchtmittel pro cm Länge umfasst.

13. Waage, insbesondere Ladenwaage, nach einem der Ansprüche 1 bis 12, **dadurch gekennzeichnet, dass** das Gehäuse eine Aussparung oder eine einseitige Aussparung umfasst, die im oberen Gehäusebereich an der Außenseite des Gehäuses umlaufend angebracht ist, in die das Leuchtband eingeklebt ist, wobei die Waage einen Diffusor umfasst, der außen am Gehäuse angebracht ist und die Aussparung abdeckt.

## Claims

1. Scale (10, 20), in particular retail scale, having a weighing module, wherein the weighing module comprises a housing (18, 28), in which a load cell (30) is accommodated, wherein the load cell (30) comprises a fixed section (31), a deformation section (32) and a movable section (33), wherein the fixed section (31) is connected to the housing (18, 28) and the movable section (33) carries a load cross (39) with a load plate (11, 21), wherein the deformation section (32) has a strain gauge (36) for measuring a weight acting on the load plate (11, 21), **characterized in that** a luminous strip (19, 29) is attached to the outer wall (47) of the housing, and is attached to the housing (18, 28) substantially circumferentially, and **in that** the scale comprise a control unit (51) comprising a state machine (52) which represents at least one technical state of the scale, wherein the control unit (51) controls the luminous strip (19, 29) on the basis of the state of the state machine (52), and **in that** the control unit applies a voltage to the luminous strip in a pulsed manner if the state machine (52) is in a first state (52a1, 52b1, 52c1, 52d1, 52e1, 52f1, 52g1), and permanently applies a voltage to the luminous strip if the state machine (52) is in a second state (52a2, 52b2, 52c2, 52d2, 52e2, 52f2, 52g2).

2. Scale, in particular retail scale, according to Claim 1, **characterized in that** a target weight is stored in a memory in the control unit, and **in that** the state machine is in the second state if the weight value measured by the load cell corresponds to the target weight, and the state machine is in the first state if the weight value measured by the load cell differs from the target weight.

3. Scale, in particular retail scale, according to Claim 2, **characterized in that** a target number of items and an average weight per item are stored in a memory in the control unit, and **in that** the control unit calculates a target weight by multiplying the target number of items by the average weight per item.

4. Scale, in particular retail scale, according to any of Claims 1 to 3, **characterized in that** the scale comprise a printer, which unrolls paper, in particular direct thermal printing paper, from a continuous roll using a motor-driven printing roller and feeds it to a printhead for direct thermal printing, and **in that** the printer comprises a sensor that determines the length of the paper consumed, and **in that** the control unit forms the difference from the paper length originally present on the continuous roll minus the length of the paper consumed since the last paper roll change, and **in that** the state machine remains in the second state as long as the difference is greater than a threshold value and the state machine switches to the first state if the difference is less than the threshold value.

5. Scale, in particular retail scale, according to any of Claims 1 to 4, **characterized in that** the control unit comprises a receiver designed for receiving data from a computer unit, wherein the state machine of the control unit transitions from the second state to the first state if the receiver receives from the computer unit a signal indicating the need for a software update.

6. Scale, in particular retail scale, according to any of Claims 1 to 5, **characterized in that** the control unit comprises a receiver designed for receiving data from a computer unit, wherein the state machine of the control unit transitions from the second state to the first state if the receiver receives from the computer unit a signal that an operator has logged on to the computer unit using their operator identifier for the purpose of serviced sales, and **in that** the state machine of the control unit transitions from the first state to the second state if the receiver receives from the computer unit a signal that an operator has logged off from the computer unit using their operator identifier.

7. Scale, in particular retail scale, according to any of Claims 1 to 6, **characterized in that** the state machine of the control unit changes from the second state to the first state if the weight value measured by the load cell represents an overload of the load cell.

8. Scale, in particular retail scale, according to any of Claims 1 to 7, **characterized in that** the state machine of the control unit is in the second state if the load cell carries out a number of weighing operations per unit time which is above a threshold value stored in the control unit, and the state machine of the control unit is in a first state if the load cell carries out a number of weighing operations per unit time which is below the threshold value.

9. Scale, in particular retail scale, according to Claim 2 or 3, **characterized in that** the state machine is in the first state if the weight value measured by the load cell differs downwards from the target weight, and **in that** the state machine is in a third state if the weight value measured by the load cell differs upwards from the target weight, and **in that** the control unit applies a voltage to the luminous strip in a pulsed manner with a first frequency if the state machine is in a first state, and **in that** the control unit applies a voltage to the luminous strip in a pulsed manner with a second frequency if the state machine is in a third state, wherein the first frequency and the second frequency are different.

10. Scale, in particular retail scale, according to Claim 9, **characterized in that** the second frequency is higher than the first frequency.

11. Scale, in particular retail scale, according to any of Claims 1 to 10, **characterized in that** the LED illuminants generate light in the wavelength range of 230 nm to 500 nm and are coated in particular with phosphor, wherein in particular the luminous strip is coated with phosphor on the side on which the LED illuminants are attached.

12. Scale, in particular retail scale, according to any of Claims 1 to 11, wherein the luminous strip consists of a flexible carrier, on which the LED illuminants are arranged, wherein the carrier comprises in particular one to ten LED illuminants per cm length.

13. Scale, in particular retail scale, according to any of Claims 1 to 12, **characterized in that** the housing comprises a cutout or a single-sided cutout provided circumferentially in the upper housing region on the outer side of the housing, into which the luminous strip is adhesively bonded, wherein the scale comprise a diffuser which is attached to the outside of the housing and covers the cutout.

## Revendications

1. Balance (10, 20), en particulier balance de magasin, comprenant un module de pesage, le module de pesage comprenant un boîtier (18, 28) dans lequel est logée une cellule de pesage (30), la cellule de pesage (30) comprenant une partie fixe (31), une partie de déformation (32) et une partie mobile (33), dans laquelle la partie fixe (31) est reliée au boîtier (18, 28) et la partie mobile (33) porte une croix de charge (39) munie d'un plateau de charge (11, 21), dans laquelle la partie de déformation (32) présente une jauge extensométrique (36) pour mesurer un poids agissant sur le plateau de charge (11, 21), **caractérisée en ce qu'**une bande lumineuse (19, 29) est fixée à la paroi extérieure (47) du boîtier et est fixée au boîtier (18, 28) de manière substantiellement périphérique, et **en ce que** la balance comprend une unité de commande (51) qui comprend une machine d'état (52) qui représente au moins un état technique de la balance, dans laquelle l'unité de commande (51) pilote la bande lumineuse (19, 29) sur la base de l'état de la machine d'état (52), et **en ce que** l'unité de commande soumet la bande lumineuse à une tension par impulsions lorsque la machine d'état (52) se trouve dans un premier état (52a1, 52b1, 52c1, 52d1, 52e1, 52f1, 52g1) et la soumet à une tension de manière permanente lorsque la machine d'état (52) se trouve dans un deuxième état (52a2, 52b2, 52c2, 52d2, 52e2, 52f2, 52g2).

2. Balance, en particulier balance de magasin, selon la revendication 1, **caractérisée en ce qu'**un poids cible est enregistré dans une mémoire dans l'unité de commande, et **en ce que** la machine d'état se trouve dans le deuxième état lorsque la valeur de poids mesurée par la cellule de pesage correspond au poids cible, et la machine d'état se trouve dans le premier état lorsque la valeur de poids mesurée par la cellule de pesage s'écarte du poids cible.

3. Balance, en particulier balance de magasin, selon la revendication 2, **caractérisée en ce qu'**un nombre de pièces cible et un poids moyen par pièce sont enregistrés dans une mémoire dans l'unité de commande, et **en ce que** l'unité de commande calcule un poids cible en multipliant le nombre de pièces cible par le poids moyen par pièce.

4. Balance, en particulier balance de magasin, selon l'une quelconque des revendications 1 à 3, **caractérisée en ce que** la balance comprend une imprimante qui déroule du papier, en particulier du papier thermique direct, à partir d'un rouleau sans fin au moyen d'un rouleau d'impression entraîné par un moteur et l'amène à une tête d'impression pour l'impression thermique directe, et **en ce que** l'imprimante comprend un capteur qui détermine la longueur du papier consommé, et **en ce que** l'unité de commande forme la différence entre la longueur de papier initialement présente sur le rouleau sans fin moins la longueur de papier consommé depuis le dernier changement de rouleau de papier, et **en ce que** la machine d'état reste dans le deuxième état tant que la différence est supérieure à une valeur seuil et la machine d'état passe au premier état lorsque la différence est inférieure à la valeur seuil.

5. Balance, en particulier balance de magasin, selon l'une quelconque des revendications 1 à 4, **caractérisée en ce que** l'unité de commande comprend un récepteur adapté pour recevoir des données d'une unité informatique, la machine d'état de l'unité de commande passant du deuxième état au premier état lorsque le récepteur reçoit de l'unité informatique un signal indiquant la nécessité d'une mise à jour du logiciel.

6. Balance, en particulier balance de magasin, selon l'une quelconque des revendications 1 à 5, **caractérisée en ce que** l'unité de commande comprend un récepteur adapté pour recevoir des données d'une unité informatique, la machine d'état de l'unité de commande passant du deuxième état au premier état lorsque le récepteur reçoit un signal de l'unité informatique, indiquant qu'un opérateur s'est connecté à l'unité informatique avec son identifiant d'opérateur pour la vente de service, et **en ce que** la machine d'état de l'unité de commande passe du premier état au deuxième état lorsque le récepteur reçoit de l'unité informatique un signal indiquant qu'un opérateur s'est déconnecté de l'unité informatique avec son identifiant d'opérateur.

7. Balance, en particulier balance de magasin, selon l'une quelconque des revendications 1 à 6, **caractérisée en ce que** la machine d'état de l'unité de commande passe du deuxième état au premier état lorsque la valeur de poids mesurée par la cellule de pesage représente une surcharge de la cellule de pesage.

8. Balance, en particulier balance de magasin, selon l'une quelconque des revendications 1 à 7, **caractérisée en ce que** la machine d'état de l'unité de commande se trouve dans le deuxième état lorsque la cellule de pesage effectue un nombre de pesées par unité de temps supérieur à une valeur seuil mémorisée dans l'unité de commande, et la machine d'état de l'unité de commande se trouve dans un premier état lorsque la cellule de pesage effectue un nombre de pesées par unité de temps qui est inférieur à la valeur seuil.

9. Balance, en particulier balance de magasin, selon la revendication 2 ou 3, **caractérisée en ce que** la machine d'état se trouve dans le premier état lorsque la valeur de poids mesurée par la cellule de pesage s'écarte vers le bas du poids cible, et **en ce que** la machine d'état se trouve dans un troisième état lorsque la valeur de poids mesurée par la cellule de pesage s'écarte vers le haut du poids cible, et **en ce que** l'unité de commande soumet la bande lumineuse à une tension à une première fréquence par impulsions lorsque la machine d'état se trouve dans un premier état, et **en ce que** l'unité de commande soumet la bande lumineuse à une tension à une deuxième fréquence par impulsions lorsque la machine d'état se trouve dans un troisième état, la première fréquence et la deuxième fréquence étant différentes.

10. Balance, en particulier balance de magasin, selon la revendication 9, **caractérisée en ce que** la deuxième fréquence est supérieure à la première fréquence.

11. Balance, en particulier balance de magasin, selon l'une quelconque des revendications 1 à 10, **caractérisée en ce que** les moyens lumineux LED génèrent de la lumière dans la plage de longueurs d'onde de 230 nm à 500 nm, et sont en particulier recouverts de phosphore, dans laquelle en particulier la bande lumineuse est recouverte de phosphore sur le côté sur lequel sont fixés les moyens lumineux LED.

12. Balance, en particulier balance de magasin, selon l'une quelconque des revendications 1 à 11, dans laquelle la bande lumineuse est constituée d'un support souple sur lequel sont agencés les moyens lumineux LED, ledit support comprenant notamment un à dix moyens lumineux LED par cm de longueur.

13. Balance, en particulier balance de magasin, selon l'une quelconque des revendications 1 à 12, **caractérisée en ce que** le boîtier comprend un évidement ou un évidement unilatéral qui est pratiqué de manière périphérique dans la partie de boîtier supérieure sur la face extérieure du boîtier dans laquelle est collée la bande lumineuse, la balance comprenant un diffuseur fixé à l'extérieur du boîtier et recouvrant l'évidement.
